# EUROPÄISCHE PATENTSCHRIFT

(11) **EP 1 515 595 B1**
(45) Veröffentlichungstag und Bekanntmachung des Hinweises auf die Patenterteilung: **11.07.2012**
(21) Anmeldenummer: 04016399.0
(22) Anmeldetag: 13.07.2004
(51) Int. Cl.: H05K 1/02, H05K 3/20

(54) **Schaltungsträger**
Circuit support
Support de circuit

(30) Priorität: 09.09.2003 DE 10341453
(43) Veröffentlichungstag der Anmeldung: 16.03.2005
(73) Patentinhaber: ROBERT BOSCH GMBH, 70442 Stuttgart (DE)
(72) Erfinder: Koelle, Gerhard, 75446 Wiernsheim (DE); Hruschka, Martin, 74232 Abstatt-Happenbach (DE); Ruf, Christoph, 72800 Eningen (DE); Kittelberger, Sven, 72762 Reutlingen (DE)

(56) Entgegenhaltungen:
- EP-A2- 1 326 275
- DE-A1- 3 520 945
- JP-A- 8 204 318
- JP-A- 10 200 265
- JP-A- 2000 315 889
- US-A- 3 161 945
- US-A- 5 362 926
- US-A1- 2001 036 065

## Beschreibung

### Stand der Technik

Die Erfindung geht aus von einem Schaltungsträger nach der Gattung des unabhängigen Anspruchs. In elektronischen Steuergeräten werden häufig Halbleiter mit erhöhten Verlustleistungen eingesetzt, die zusammen mit passiven Bauelementen auf anwendungsspezifisch strukturiert Leistungssubstrate gelötet werden. Als Leistungssubstrate kommen beispielsweise so genannte DBC-Keramiksubstrat in Betracht, die aus einer beidseitig mit Kupfer belegten Keramik (z.B. 630 µm) bestehen, wobei die Kupferschichten eine Dicke von ca. 300 µm aufweisen. Die Keramik stellt die elektrische Isolation der Leiterbahnen auf der Oberseite sicher sowie die thermische Ankopplung der auf die Leiterbahnen aufgelöteten Leistungshalbleiter zur Unterseite. Die Anschlüsse der Leistungshalbleiter werden über Dickdraht-Bonds mit den Leiterbahnen des Leistungssubstrates verbunden. Um die im Betrieb entstehende Verlustwärme abzuführen, wird das Leistungssubstrat auf einen anwendungsspezifischen Kühlkörper geklebt. Der dafür eingesetzte Klebstoff besitzt zwar eine im Vergleich zu anderen Klebstoffen höhere Wärmeleitfähigkeit, stellt aber dennoch einen erheblichen thermischen Widerstand dar.

Aus der DE 35 20 945 C2 ist bereits ein Trägerelement zur Aufnahme elektronischer Bauteile bekannt, bei dem auf einer Wärmesenke, vorzugsweise einem Kühlkörper, Leiterbahnen angeordnet sind. Zur elektrischen Isolation ist zwischen den Leiterbahnen und der Wärmesenke eine Emailschicht angeordnet.

Aus der US 3 161 945 A ist eine Leiterplattenstruktur bekannt, bei der eine Leiterbahn aus einem porösen metallischen Material mittels eines härtbaren Kunststoffs in eine isolierende Basisplatte eingebettet ist. Der härtbare Kunststoff fließt dabei während des Härtvorgangs in die Poren des porösen metallischen Materials und füllt diese vollständig aus.

Aus der US 2001/0036065 A1 ist bekannt, eine Leiterplatte mit hoher Wärmeleitfähigkeit herzustellen, indem zwischen einer als Wärmesenke dienenden Metallplatte und einem Leadframe eine Schicht aus einem thermisch leitfähigen Kunststoff vorgesehen ist.

Aus US 5 362 926 A ist ein Schaltungsträger bekannt, bei dem Leiterbahnen aus einer mit Kupfer beschichteten Aluminium Folie auf ein metallisches Trägersubstrat mittels einer isolierenden Zwischenschicht aufgebracht wird. Dabei weist die Folie eine bestimmte Oberflächenrauigkeit auf, um die mechanische Verbindung zu der isolierenden Zwischenschicht zu stärken.

### Vorteile der Erfindung

Der erfindungsgemäße Schaltungsträger mit den Merkmalen des unabhängigen Anspruchs hat demgegenüber den Vorteil, dass die Klebeschicht, in die Leiterbahnen aus Metallgitter (metallisches Gewebe oder Streckgitter) eingebracht werden, im Aufbau eine geringere Höhe aufweist, als bei herkömmlicher Klebemontage von Leiterbahn-Strukturen. Durch die geringere Aufbauhöhe der erfindungsgemäßen Leiterbahnen ist in vorteilhafter Weise auch der thermische Widerstand der Leiterbahnen in Richtung Trägersubstrat verringert, sodass auf den Leiterbahnen angeordnete Bauelemente effektiver entwärmt werden.

Durch die in den Unteransprüchen aufgeführten Maßnahmen sind vorteilhafte Weiterbildungen und Verbesserungen des im unabhängigen Anspruchs angegebenen Schaltungsträgers möglich.

Besonders vorteilhaft ist das Trägersubstrat metallisch ausgeführt und die Klebeschicht elektrisch isolierend, sodass die Wärme von Bauelementen vorteilhaft über das metallische Trägersubstrat abgeführt werden kann.

Gemäß einer weiteren bevorzugten Ausführungsform ist das Trägersubstrat eine Wärmesenke, sodass in vorteilhafter Weise insbesondere Leistungsbauelemente wirkungsvoll entwärmt werden.

Ein besonderer Vorteil dieser Ausführungsform ist die reduzierte Klebschichtdicke unter dem Metallgitter, da die mechanische Haftung vor allem über die seitliche Benetzung des Metallgitters mit dem Klebstoff gegeben ist. Die durch die reduzierte Klebstoffschichtdicke geringere Reißdehnung wird über die Elastizität des Metallgitters zumindest ausgeglichen.

### Beschreibung der Ausführungsbeispiele

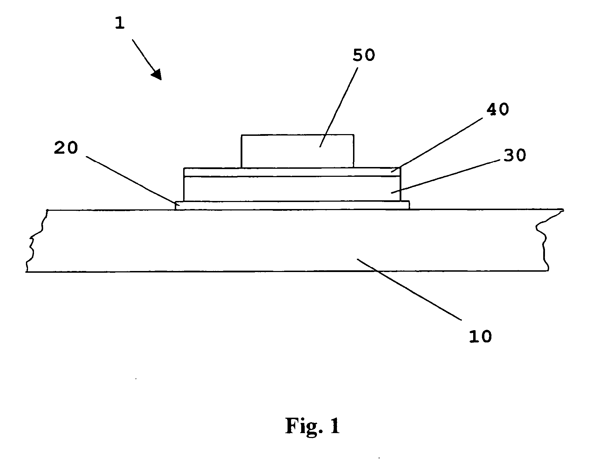

In der einzigen Zeichnung Figur 1 ist ein Ausführungsbeispiel eines erfindungsgemäßen Schaltungsträgers 1 gezeigt. Auf einem Trägersubstrat 10 ist eine Klebeschicht 20 angeordnet auf der wiederum in kleinerer Abmessung ein Metallgitter 30 angeordnet ist. Das Bauelement 50 ist über eine Lotschicht 40 mit dem Metallgitter 30 Wärme leitend und gegebenenfalls elektrisch leitend verbunden.

In einer bevorzugten Ausführungsform ist das Trägersubstrat 10 als Wärmesenke, beispielsweise als Keramikkörper oder metallischer Kühlkörper, ausgeführt. Ist die Wärmesenke elektrisch nicht leitend ausgeführt, so kann die aufgebrachte Klebeschicht 20 sowohl elektrischen leitend als auch elektrisch nicht leitend ausgeführt sein. Bei einer elektrisch leitenden Wärmesenke 10, wie es bei einem metallischen Kühlkörper der Fall ist, ist die Klebeschicht 20 elektrisch nicht leitend auszuführen.

Als Klebeschicht können übliche elektrisch leitende oder nicht leitende Polymere eingesetzt werden. Insbesondere eignen sich für elektrisch nicht leitende Klebeschicht elektrisch isolierend Lacke, die mit Wärme leitenden Partikeln, beispielsweise AIN, Al203, SiC o.ä., angereichert sind. Um den thermischen Widerstand der Klebeschichten 20 möglichst gering zuhalten, sind geringe Schichtdicken der Klebeschicht 20 zu bevorzugen. Typische Schichtdicken sollten kleiner 200 Mikrometern oder besser kleiner 50 Mikrometer sein.

In einer Ausführungsvariante können auf dieser Klebeschicht 20 Leiterbahnen vollflächig aufgeklebt werden. Die Haftung der vollflächig aufgebrachte Leiterbahnen wird im Wesentlichen durch die Adhäsion an der Grenzfläche zwischen Klebeschicht und Leiterbahnfläche hergestellt.

In der bevorzugten Ausführungsform ist die Leiterbahn erfindungsgemäß als Metallgitter 30 ausgeführt. Im Gegensatz zu einer vollflächigen Leiterbahn dringt das Metallgitter 30 auch in die Klebeschicht 20 ein. Durch das Einbringen des Metallgitter 30 in die Klebeschicht 20 wird ein inniger Verbund mit der Klebeschicht 20 hergestellt und die Haftung der als Metallgitter 30 ausgeführten Leiterbahn wird im Vergleich zu einer vollflächigen Leiterbahn deutlich verbessert.
Darüber hinaus ist auch die Zuverlässigkeit des Metallgitteraufbaus nach Temperaturwechsel deutlich besser als bei vollflächigen Leiterbahnen.

In einer weiteren Ausführungsvariante können zusätzlich zu den als Metallgitter ausgeführten Leiterbahnen auch Leiterbahnen in herkömmlicher Technik und in üblichen Bauformen auf dem Trägersubstrat angeordnet sein.

Zur Herstellung einer elektronischen Schaltung wird in einer bevorzugten Ausführungsform in einem ersten Schritt eine elektrisch nicht leitende Klebeschicht 20 auf einem metallischen Trägersubstrat 10 aufgebracht. In einem zweiten Schritt wird eine Leiterbahn, die als metallisches Gewebe 30 ausgebildet ist, auf die Klebeschicht 20 aufgebracht. Die Klebeschicht 20 ist entweder frisch aufgebracht oder lässt sich noch plastisch verformen, sodass das metallische Gewebe 30 erfindungsgemäß in die Klebeschicht 20 eindringen kann. Das Einbringen des metallischen Gewebes 30 darf hierbei nur insoweit erfolgen, dass eine ausreichende elektrische Isolation zur metallischen Wärmesenke 10 gewährleistet ist und ferner genügend metallisches Material au-Berhalb der Klebeschicht 20 zur Verfügung steht. Vor dem Aushärten der Klebeschicht 20 kann vorgesehen sein das Metallgitter 30 an der Oberfläche zu glätten. Das Glätten der Oberfläche des Metallgitters verbessert die flächige Anbindung der Leistungshalbleiter und ermöglicht die Schaffung von Bondflächen zur Kontaktierung der Leistungshalbleiter. In einem weiteren Schritt wird ein Bauelement 50 auf das metallische Gewebe 30 aufgelötet. Die Lotschicht 40 verbindet das Bauelement 50 thermisch und gegebenenfalls elektrisch mit dem metallischen Gewebe 30. Die Lotschicht 40 dringt ferner in die Zwischenräumen des Metallgewebes 30 und füllt diese aus, wodurch sich der thermische Widerstand des gesamten Verbundes weiter reduziert.

Das Auflöten des Bauelementes 50 kann beispielsweise in einem Reflow-Prozess erfolgen, bei dem zwischen Bauelement und dem metallischen Gewebe 30 eine Lot-Preform angeordnet oder Lotpaste dispenst wird, dann im Reflow-Prozess aufgeschmolzen und die Verbindung hergestellt wird. In einer weiteren Variante kann im Vorfeld das metallische Gewebe 30 beispielsweise in einem Schwall-Lötverfahren vorbelotet werden und Bauelemente in einem späteren Prozess-Schritt angeordnet werden.

Darüber hinaus ist es denkbar an Stelle eines Lotes einen elektrisch leitfähigen Klebstoff einzusetzen.

## Patentansprüche

1. Schaltungsträger (1) mit einem Trägersubstrat (10), mit wenigstens einer Klebeschicht (20) und wenigstens einer Leiterbahn, **dadurch gekennzeichnet, dass** wenigstens eine Leiterbahn ein Metallgitter (30) ist, dass das Metallgitter (30) auf der Klebeschicht (20) angeordnet ist und dass metallisches Material des Metallgitters (30) außerhalb der Klebeschicht (20) zur Verfügung steht, so dass Lot (40) in die Zwischenräume des Metallgitters (30) eindringen kann.

2. Schaltungsträger (1) nach Anspruch 1, **dadurch gekennzeichnet, dass** das Trägersubstrat (10) metallisch und die Klebeschicht (20) elektrisch isolierend ist.

3. Schaltungsträger (1) nach Anspruch 1 oder 2, **dadurch gekennzeichnet, dass** das Trägersubstrat (10) eine Wärmesenke ist.

4. Verfahren zur Herstellung einer elektronischen Schaltung mit den Schritten:
- Aufbringen wenigstens einer elektrisch nicht leitenden Klebeschicht (20) auf einem metallischen Trägersubstrat (10),
- Aufbringen wenigstens eines Metallgitters (30),
- Auflöten eines Bauelementes (50) auf dem Metallgitter (30), wobei metallisches Material des Metallgitters (30) außerhalb der Klebeschicht (20) zur Verfügung steht, so dass Lot (40) in die Zwischenräume des Metallgitters (30) eindringen kann.

5. Verfahren nach Anspruch 4, **dadurch gekennzeichnet, dass** das Metallgitter (30) vor dem Aushärten der Klebeschicht (20) geglättet wird.

6. Verfahren nach mindestens einen der Ansprüche 4 oder 5, **dadurch gekennzeichnet, dass** das Metallgitter (30) vor dem Auflöten eines Bauelementes (50) belotet wird.

## Claims

1. Circuit carrier (1) comprising a carrier substrate (10), comprising at least one adhesive layer (20) and at least one conductor track, **characterized in that** at least one conductor track is a metal grid (30), **in that** the metal grid (30) is arranged on the adhesive layer (20), and **in that** metallic material of the metal grid (30) is available outside the adhesive layer (20), such that solder (40) can penetrate into the interspaces of the metal grid (30).

2. Circuit carrier (1) according to Claim 1, **characterized in that** the carrier substrate (10) is metallic and the adhesive layer (20) is electrically insulating.

3. Circuit carrier (1) according to Claim 1 or 2, **characterized in that** the carrier substrate (10) is a heat sink.

4. Method for producing an electronic circuit comprising the following steps:
- applying at least one electrically non-conductive adhesive layer (20) on a metallic carrier substrate (10),
- applying at least one metal grid (30),
- soldering a component (50) on the metal grid (30), wherein metallic material of the metal grid (30) is available outside the adhesive layer (20), such that solder (40) can penetrate into the interspaces of the metal grid (30).

5. Method according to Claim 4, **characterized in that** the metal grid (30) is smoothed before the adhesive layer (20) is cured.

6. Method according to at least one of Claims 4 and 5, **characterized in that** the metal grid (30) is soldered before a component (50) is soldered on.

## Revendications

1. Support de circuit (1) présentant un substrat de support (10), au moins une couche adhésive (20) et au moins une piste conductrice,
**caractérisé en ce que**
la ou les pistes conductrices forment une grille métallique (30),
**en ce que** la grille métallique (30) est disposée sur la couche adhésive (20) et
**en ce que** le matériau métallique de la grille métallique (30) est accessible à l'extérieur de la couche adhésive (20) de telle sorte que de la brasure (40) puisse pénétrer dans les espaces intermédiaires de la grille métallique (30).

2. Support de circuit (1) selon la revendication 1, **caractérisé en ce que** le substrat de support (10) est métallique et la couche adhésive (20) est électriquement isolante.

3. Support de circuit (1) selon les revendications 1 ou 2, **caractérisé en ce que** le substrat de support (10) est un drain thermique.

4. Procédé de fabrication d'un circuit électronique, comportant les étapes qui consistent à
- appliquer au moins une couche adhésive (20) électriquement non conductrice sur un substrat métallique de support (10),
- appliquer au moins une grille métallique (30),
- braser un composant (50) sur la grille métallique (30), le matériau métallique de la grille métallique (30) étant accessible à l'extérieur de la couche adhésive (20) de telle sorte que de la brasure (40) puisse pénétrer dans les espaces intermédiaires de la grille métallique (30).

5. Procédé selon la revendication 4, **caractérisé en ce que** la grille métallique (30) est lissée avant l'application de la couche adhésive (20).

6. Procédé selon au moins l'une des revendications 4 ou 5, **caractérisé en ce que** la grille métallique (30) est enduite de brasure avant le brasage d'un composant (50).
